(19) Europäisches Patentamt

European Patent Office

Office européen des brevets

(11) **EP 1 645 885 A1**

(12) **EUROPÄISCHE PATENTANMELDUNG**

(43) Veröffentlichungstag:
12.04.2006 Patentblatt 2006/15

(51) Int Cl.:
*G01R 19/175* [(2006.01)]     *H02M 7/42* [(2006.01)]

(21) Anmeldenummer: 04405635.6

(22) Anmeldetag: 08.10.2004

(84) Benannte Vertragsstaaten:
**AT BE BG CH CY CZ DE DK EE ES FI FR GB GR HU IE IT LI LU MC NL PL PT RO SE SI SK TR**
Benannte Erstreckungsstaaten:
**AL HR LT LV MK**

(71) Anmelder: **ABB RESEARCH LTD.**
**8050 Zürich (CH)**

(72) Erfinder:
• **Akdag, Alper**
**5406 Baden-Rütihof (CH)**

• **Stefanutti, Philippe**
**74300 Choisy (FR)**
• **Meysenc, Luc**
**5405 Baden-Dättwil (CH)**
• **Hugo, Nicolas**
**1201 Genève (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(54) **Verfahren zur Bestimmung des Stromnulldurchgangs in einem Umrichter**

(57)     Ein Umrichter wird mit mindestens zwei Stromrichterzweigen betrieben, wobei der Strom abwechselnd über mindestens einen ersten und über mindestens einen zweiten Stromrichterzweig fliesst. Der Zeitpunkt eines Stromnulldurchgangs in dem Umrichter wird dadurch bestimmt, dass der Strom mittels einer Vorrichtung zur Bestimmung des Zeitpunkts des Stromnulldurchgangs gemessen wird, der gemessene Stromwert in der Vorrichtung mit einem Strom-Schwellwert verglichen wird und anhand des Zeitpunkts, an dem der Stromwert den Wert des Strom-Schwellwerts vor dem Stromnulldurchgang erreicht, eine voraussichtliche Zeitdauer t von dem Erreichen des Strom-Schwellwerts bis zum Erreichen des Stromnulldurchgangs mittels der Vorrichtung berechnet wird.

**Beschreibung**

*Technisches Gebiet*

Die Erfindung bezieht sich auf das Gebiet der Leistungselektronik. Sie betrifft ein Verfahren zur Bestimmung des Zeitpunkts des Stromnulldurchgangs in einem Umrichter mit den Merkmalen des Oberbegriffs des Anspruchs 1, eine Vorrichtung zur Durchführung dieses Verfahrens und einen Umrichter.

*Stand der Technik*

Stromgeführte Umrichter dienen zur Umwandlung von einem Eingangsstrom in einen ein- oder mehr-phasigen Wechselstrom. Die Umrichter enthalten zwei Stromrichterzweige, über die ein Strom I(t) fliessen kann. Jeder der Stromrichterzweige kann durch ein Stromventil in einen Leitzustand oder in einen Sperrzustand geschaltet werden. Ein erstes Stromventil im ersten Stromrichterzweig wird während einer Halbwelle des Stroms, bei welcher der Strom entweder durchgehend positiv oder negativ ist, in Leitzustand geschaltet. Wenn der Strom sein Vorzeichen wechselt, wird das erste Stromventil in Sperrzustand geschaltet und ein zweites Ventil im zweiten Stromrichterzweig, welches während der Zeitdauer, in dem das erste Stromventil in Leitzustand war, in Sperrzustand war, nun in Leitzustand geschaltet. Erfolgt der Übergang von einem Stromrichterzweig in den anderen jedoch nicht genau zu dem Zeitpunkt, an dem der Strom sein Vorzeichen wechselt, kommt es zu einem Überlappungsbereich, in dem beide Stromrichterzweige Strom führen oder zu einem Bereich, in dem in keinem der Stromrichterzweige Strom fliesst. Dieser Überlappungsbereich bzw. der Bereich, in dem in keinem der Stromrichterzweige Strom fliesst, führt jedoch zu grossen Energieverlusten und Einschwingvorgängen.

Zur Bestimmung des Zeitpunktes, an dem die Stromventile geschaltet werden sollen, sind komplexe Verfahren entwickelt worden, welche eine Messung des Stroms beinhalten. Ein solches Verfahren wird in einem Dokument von S. Väliviita, Ovaska S.J., Kyyrä J. ("adaptive signal processing system for accurate zerocrossing detection of cycloconverter phase currents"; IEEJ 1997 - PCC Nagoka, p. 467-472) beschrieben. In dem Verfahren wird ein Niederfrequenz-Vorfilter benutzt, um unerwünschte niederfrequente Frequenzanteile aus dem Stromsignal zu filtern und durch ein mehrstufiges adaptives digitales Filter wird ein sinusförmiger Verlauf des Stromsignals rekonstruiert, aus dem anschliessend der Zeitpunkt des Stromnulldurchgangs vorhergesagt werden kann.

Dieses Verfahren ist jedoch aufwendig und kostenspielig. Fehler in den Strommessungen und des Strom-Offsets setzen die Zuverlässigkeit und Genauigkeit der Bestimmung des Zeitpunkts des Stromnulldurchgangs herab.

*Darstellung der Erfindung*

Aufgabe der Erfindung ist, ein Verfahren und eine Vorrichtung der eingangs genannten Art zu schaffen, die eine genaue und einfachere Vorhersage des Zeitpunkts des Stromnulldurchgangs in einem Umrichter ermöglichen.

Diese Aufgabe wird erfindungsgemäss durch ein Verfahren zur Stromnulldurchgangsbestimmung in einem Umrichter mit den Merkmalen des Patentanspruchs 1, eine Vorrichtung zur Bestimmung des Zeitpunkts des Stromnulldurchgangs mit den Merkmalen des Patentanspruchs 8 und einen Umrichter mit den Merkmalen des Patentanspruchs 9 gelöst.

Bei dem erfindungsgemässen Verfahren wird der Strom im Umrichter mittels einer Vorrichtung zur Bestimmung des Zeitpunkts des Stromnulldurchgangs gemessen, der gemessene Stromwert in der Vorrichtung mit einem Strom-Schwellwert verglichen und anhand des Zeitpunkts, an dem der Stromwert den Wert des Strom-Schwellwerts vor dem Stromnulldurchgang erreicht, eine voraussichtlichen Zeitdauer $\Delta t$ von dem Erreichen des Strom-Schwellwerts bis zum Erreichen des Stromnulldurchgangs mittels der Vorrichtung ermittelt. Da nur eine Messgrösse zu bestimmen ist und nur einfache Berechnungen notwendig sind, ist dieses Verfahren einfach durchzuführen.

Bei einem sinusförmigen oder annähernd sinusförmigen Verlauf des Stroms lässt sich der Strom in zwei Halbwellen aufteilen, von denen jede Halbwelle die Zeitdauer umfasst, in denen der Strom entweder durchgehend grösser oder durchgehend kleiner als Null ist. Aus den in einer positiven Halbwelle gemessenen Strömen oder den in einer negativen Halbwelle gemessenen Strömen wird eine maximale Amplitude des Stroms der Halbwelle $I_{max}$ bestimmt und die maximale Amplitude des Stroms zur Bestimmung des Zeitpunkts des Stromnulldurchgangs verwendet. Durch die Ermittlung der maximalen Amplitude des Stroms einer Halbwelle wird die Genauigkeit des Verfahrens erhöht.

Die voraussichtliche Zeitdauer $\Delta t$ von dem Erreichen des Strom-Schwellwerts $I_{set}$ bis zum Erreichen des Stromnulldurchgangs kann bei Erreichen des Strom-Schwellwerts vor dem Stromnulldurchgang bestimmt werden aus einem Betrag des Strom-Schwellwerts $|I_{set}|$, der maximalen Amplitude des Stroms $I_{max}$ und einer Frequenz w des Stroms mittels der Gleichung:

$$\Delta t = \omega * \frac{|I_{set}|}{I_{max}}$$ , wobei als Strom-Schwellwert $I_{set}$ in

der negativen Halbwelle ein negativer Strom-Schwellwert $I_{set,n}$ und in der positiven Halbwelle ein positiver Strom-Schwellwert $I_{set,p}$ eingesetzt wird. Vorteil dieser Ausführungsform ist, dass nur wenige, einfach zu bestimmende Messwerte in die Bestimmung des Stromnulldurchgangs eingehen, und die Bestimmung des Zeitpunkts des Stromnulldurchgangs mittels einer einfachen Gleichung und daher schnell erfolgt.

Weitere vorteilhafte Varianten und Ausführungsformen gehen aus den abhängigen Patentansprüchen hervor.

### Kurze Beschreibung der Zeichnungen

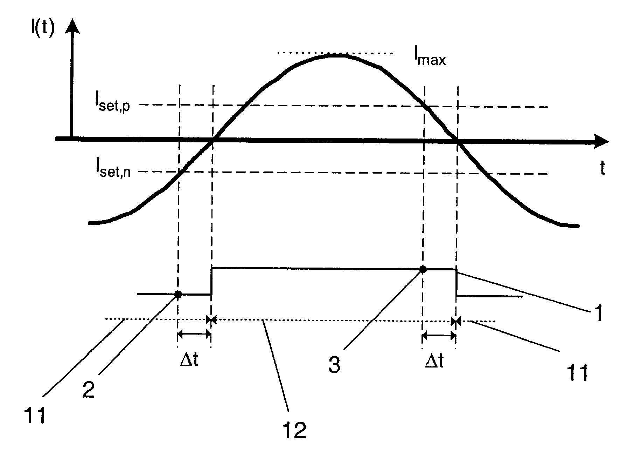

Im folgenden wird das erfindungsgemässe Verfahren und der Erfindungsgegenstand anhand eines bevorzugten Ausführungsbeispiels, welches in der beiliegenden Zeichnung dargestellt ist, näher erläutert. Die Figur zeigt einen Verlauf des Stroms über die Zeit in einem Umrichter und Schaltverhalten eines ersten Stromventils in einem ersten Stromrichterzweig.

### Wege zur Ausführung der Erfindung

Im folgenden Beispiel wird ein Umrichter mit zwei Stromrichterzweigen beschrieben, die Erfindung ist aber auch anwendbar auf ein- oder mehrphasige Umrichter mit mindestens zwei Stromrichterzweigen.

Die Figur zeigt den Stromverlauf über die Zeit und das Schaltverhalten eines ersten Stromventils in einem ersten Stromrichterzweig. Der Strom im Umrichter wird mittels einer Vorrichtung zur Bestimmung des Zeitpunkts des Stromnulldurchgangs des Umrichters gemessen. Anhand der Kurve 1 ist gezeigt, dass von der negativen Halbwelle aus beginnend von den gemessenen Stromwerten des Umrichters die maximale Amplitude des Stroms $I_{max}$ der negativen Halbwelle bestimmt wird (der Übersichtlichkeit wegen nicht in der Figur dargestellt). Die Ermittlung erfolgt mit einem gängigen Berechnungsverfahren. Bei Erreichen eines negativen Strom-Schwellwerts $I_{set, n}$ nach Durchlaufen der maximalen Amplitude des Stroms und vor dem Stromnulldurchgang 2 wird eine voraussichtliche Zeitdauer $\Delta t$ von dem Erreichen des Strom-Schwellwerts bis zum Erreichen des Stromnulldurchgangs ermittelt. In der positiven Halbwelle wird die maximale Amplitude des Stroms $I_{max}$ bestimmt und bei Erreichen eines positiven Strom-Schwellwerts $I_{set, p}$ nach Durchlaufen der maximalen Amplitude des Stroms und vor dem Stromnulldurchgang 3 die voraussichtliche Zeitdauer $\Delta t$ von dem Erreichen des Strom-Schwellwerts bis zum Erreichen des Stromnulldurchgangs ermittelt.

Der momentane Strom $I(t)$ ergibt sich aus der maximalen Amplitude des Stroms $I_{max}$, der Frequenz w und der Zeit t nach folgender Gleichung:

$$I(t) = I_{max} \sin(\omega t)$$

Bei kleinen Werten für (wt) kann man $|\sin(wt)| \approx \omega t$ setzen. Dadurch vereinfacht sich die Gleichung für den Momentanstrom und man kann für einen Betrag des Stromwerts $|I(t)|$ die voraussichtliche Zeitdauer $\Delta t$ von

dem Erreichen des Strom-Schwellwerts bis zum Erreichen des Stromnulldurchgangs bestimmen:

$$\Delta t = \omega * \frac{|I(t)|}{I_{max}}$$

Bei Erreichen eines vorgegebenen Strom-Schwellwerts $I_{set}$ vor dem Stromnulldurchgang kann die voraussichtliche Zeitdauer $\Delta t$ von dem Erreichen des Strom-Schwellwerts bis zum Erreichen des Stromnulldurchgangs mit der oben angegebenen Gleichung und einem Betrag des Strom-Schwellwerts $|I_{set}|$ wie folgt ermittelt werden.

$$\Delta t = \omega * \frac{|I_{set}|}{I_{max}},$$

wobei als Strom-Schwellwert $I_{set}$ in der negativen Halbwelle $I_{set,n}$ und in der positiven Halbwelle $I_{set, p}$ eingesetzt wird.

Kurve 1 zeigt, dass aufgrund der Ermittlung der voraussichtlichen Zeitdauer $\Delta t$ von dem Erreichen des Strom-Schwellwerts bis zum Erreichen des Stromnulldurchgangs die Umschaltung zwischen zwei Stromrichterzweigen um die Zeitdauer $\Delta t$ nach Erreichen des vorgegebenen Strom-Schwellwerts verzögert ausgelöst wird. In der Figur ist der Übersichtlichkeit wegen nur der Zustand des ersten Stromrichterzweiges gezeigt. In der negativen Halbwelle ist der erste Stromrichterzweig in Leitzustand 11 und der zweite Stromrichterzweig in Sperrzustand. Nach Ablauf der Zeitdauer $\Delta t$ nach Erreichen des vorgegebenen negativen Strom-Schwellwerts $I_{set, n}$ wird der erste Stromrichterzweig in Sperrzustand geschaltet 12 und der zweite Stromrichterzweig in Leitzustand. In der positiven Halbwelle wird nach Ablauf der Zeitdauer $\Delta t$ nach Erreichen des vorgegebenen positiven Strom-Schwellwerts $I_{set, p}$ der erste Stromrichterzweig wieder in Leitzustand geschaltet 11 und der zweite Stromrichterzweig in Sperrzustand.

Der Strom-Schwellwert $I_{set, n}$ für die negative Halbwelle und $I_{set, p}$ für die positive Halbwelle kann betriebsabhängig vorgegeben werden. Falls der Strom beeinflusst wird von Rauschen, kann der Wert vorteilhafterweise so gross gewählt werden, dass der Stromwert deutlich vom Rauschen unterschieden werden kann. Andererseits sollte der Stromwert so niedrig sein, dass der Fehler, den man durch die Näherung von $|\sin(\omega t)| \approx$ wt macht, klein bleibt.

Die maximale Amplitude des Stroms kann innerhalb jeder Halbwelle neu bestimmt werden, es ist aber auch denkbar, nur für jede zweite oder höchstens jede zweite Halbwelle eine maximale Amplitude des Stroms neu zu bestimmen. Wenn die maximale Amplitude innerhalb einer Halbwelle bestimmt wird und dieser Wert für die Ermittlung der Zeitdauer bis zum direkt darauf folgenden Stromnulldurchgang benutzt wird, erhält man ein besonders genaues Ergebnis. Wenn die maximale Amplitude des Stroms erst für die Ermittlung der Zeitdauer bis zu einem späteren Stromnulldurchgang verwendet wird oder wenn die maximale Amplitude nicht für jede Halbwelle neu bestimmt wird, kann das Verfahren besonders schnell durchgeführt werden.

Besonders einfach wird das Verfahren auch, wenn der Betrag des negativen Strom-Schwellwerts $|I_{set,n}|$ gleich dem Betrag des positiven Strom-Schwellwerts $|I_{set,p}|$ ist. Dann kann eine Konstante aus dem Produkt aus der Frequenz w und des Strom-Schwellwerts ermittelt werden und in jeder Halbwelle braucht nur der Quotient aus der Konstante und der maximalen Amplitude des Stroms einer Halbwelle berechnet zu werden, um die voraussichtliche Zeitdauer $\Delta t$ von dem Erreichen des Strom-Schwellwerts bis zum Erreichen des Stromnulldurchgangs zu bestimmen.

Das erfindungsgemässe Verfahren zur Stromnulldurchgangsbestimmung in einem Umrichter kann mittels einer Vorrichtung, die ein Mittel zur Messung des Stroms und ein Datenverarbeitungssystem zum Vergleich der Strom-Schwellwerte und zur Ermittlung der voraussichtlichen Zeitdauer von dem Erreichen des Strom-Schwellwerts bis zum Erreichen des Stromnulldurchgangs umfasst, durchgeführt werden. Bei dem Verfahren wird der Strom mittels der Vorrichtung gemessen, der gemessene Stromwert in der Datenverarbeitungssystem mit einem Strom-Schwellwert $I_{set}$ verglichen und anhand des Zeitpunkts, an dem der Strom den Wert des Strom-Schwellwerts vor dem Stromnulldurchgang erreicht, eine voraussichtliche Zeitdauer $\Delta t$ von dem Erreichen des Strom-Schwellwerts bis zum Erreichen des Stromnulldurchgangs mittels des Datenverarbeitungssystems ermittelt.

Ein Computerprogramm für die Stromnulldurchgangsbestimmung ist ladbar in das Datenverarbeitungssystem und ausführbar in dem Datenverarbeitungssystem. Wenn das Computerprogramm ausgeführt wird, vergleicht es den gemessenen Stromwert mit einem Strom-Schwellwert $I_{set}$ und ermittelt anhand des Zeitpunkts, an dem der Strom den Wert des Strom-Schwellwerts vor dem Stromnulldurchgang erreicht, eine voraussichtliche Zeitdauer $\Delta t$ von dem Erreichen des Strom-Schwellwerts bis zum Erreichen des Stromnulldurchgangs.

In einer anderen Variante des Verfahrens wird der Stromnulldurchgang in einem Umrichter bestimmt mittels einer Vorrichtung, die ein Mittel zur Messung des Stroms und einen elektrischen Schaltkreis zum Vergleich des Strom-Schwellwerts sowie zur Ermittlung der voraussichtlichen Zeitdauer von dem Erreichen des Strom-Schwellwerts bis zum Erreichen des Stromnulldurchgangs umfasst.

Bei Umrichtern kann vor jedem Stromrichterzweig ein Ventil eingebaut sein, durch das ein Stromrichterzweig in einen Sperrzustand oder Leitzustand geschaltet werden kann. Wenn ein solches Ventil die Umschaltung des jeweiligen Stromrichterzweiges zeitverzögert von dem Zeitpunkt vornimmt, an dem die Umschaltung ausgelöst wird, kann die Zeitverzögerung bis zum Umschalten derart berücksichtigt werden, dass der Strom-Schwellwert so gross gewählt wird, dass die voraussichtliche Zeitdauer $\Delta t$ von dem Erreichen des Strom-Schwellwerts bis zum Erreichen des Stromnulldurchgangs grösser oder gleich der Zeitverzögerung bis zum Umschalten ist. Die Zeitverzögerung kann derart in der Ermittlung der voraussichtlichen Zeitdauer $\Delta t$ von dem Erreichen des Strom-Schwellwerts bis zum Erreichen des Stromnulldurchgangs berücksichtigt werden, dass das jeweilige Ventil zu einem Zeitpunkt vor einem Stromnulldurchgang, welcher der Zeitverzögerung entspricht, geschaltet wird und das Ventil zum Zeitpunkt des Stromnulldurchgangs sperrt oder durchlässt.

Das vorgängig beschriebene Verfahren zum Betreiben eines Umrichters kann in einem Umrichter angewendet werden, in dem ein kontinuierlicher Stromfluss gefordert ist und in dem der Stromfluss nicht durch einen aktiv herbeigeführten Vorgang wie das Schalten eines Ventils unterbrochen werden soll.

Eine weitere Anwendung des Verfahrens findet in einem stromgeführten Umrichter statt. In einem stromgeführten Umrichter verhält sich der Strom, der in den Umrichter gespeist wird, wie eine Stromquelle und am Ausgang des Umrichters wird eine Strommenge unabhängig von der Ausgangsspannung abgegeben (wie eine Stromquelle).

Das Verfahren kann auch in einem Direkt-Umrichter angewendet werden, in dem Wechselstrom einer vorgegebenen Frequenz in Wechselstrom einer anderen Frequenz direkt umgewandelt wird, ohne dass der Wechselstrom zwischenzeitlich in Gleichstrom umgewandelt wird.

**Patentansprüche**

1. Verfahren zur Stromnulldurchgangsbestimmung in einem Umrichter mit mindestens zwei Stromrichterzweigen, wobei der Strom abwechselnd über mindestens einen ersten und über mindestens einen zweiten Stromrichterzweig fliesst und mit einer Vorrichtung zur Bestimmung des Zeitpunkts des Stromnulldurchgangs, **dadurch gekennzeichnet, dass** der Strom mittels der Vorrichtung gemessen wird, der gemessene Stromwert in der Vorrichtung mit einem Strom-Schwellwert $I_{set}$ verglichen wird und anhand des Zeitpunkts, an dem der Strom den Wert des Strom-Schwellwerts $I_{set}$ vor dem Stromnulldurchgang erreicht, eine voraussichtliche Zeitdauer $\Delta t$ von dem Erreichen des Strom-Schwellwerts $I_{set}$ bis zum Erreichen des Stromnulldurchgangs mittels der Vorrichtung ermittelt wird.

**2.** Verfahren nach Anspruch 1, **dadurch gekennzeichnet, dass** der Strom einen sinusförmigen Verlauf aufweist und aus den gemessenen Stromwerten eine maximale Amplitude des Stroms $I_{max}$ in einer positiven und / oder negativen Halbwelle bestimmt wird und der Wert der maximalen Amplitude des Stroms einer Halbwelle zur Bestimmung der voraussichtlichen Zeitdauer $\Delta t$ von dem Erreichen des Strom-Schwellwerts $I_{set}$ bis zum Erreichen des Stromnulldurchgangs verwendet wird.

**3.** Verfahren nach Anspruch 2, **dadurch gekennzeichnet, dass** die voraussichtliche Zeitdauer $\Delta t$ von dem Erreichen des Strom-Schwellwerts $I_{set}$ bis zum Erreichen des Stromnulldurchgangs innerhalb derselben Halbwelle, von welcher die maximale Amplitude des Stroms $I_{max}$ ermittelt wird, bestimmt wird.

**4.** Verfahren nach einem der Ansprüche 2 oder 3, **dadurch gekennzeichnet, dass** die voraussichtliche Zeitdauer $\Delta t$ von dem Erreichen des Strom-Schwellwerts $I_{set}$ bis zum Erreichen des Stromnulldurchgangs bestimmt wird aus einem Betrag des Strom-Schwellwerts $|I_{set}|$, der maximalen Amplitude des Stroms $I_{max}$ und einer Frequenz $\omega$ des Stroms mittels der Gleichung: $$\Delta t = \omega * \frac{|I_{set}|}{I_{max}}$$ wobei als Strom-Schwellwert $I_{set}$ in der negativen Halbwelle ein negativer Strom-Schwellwert $I_{set,n}$ und in der positiven Halbwelle ein positiver Strom-Schwellwert $I_{set}$, p eingesetzt wird.

**5.** Verfahren nach Anspruch 4, **dadurch gekennzeichnet, dass** ein Betrag des negativen Strom-Schwellwerts $|I_{set,n}|$ und ein Betrag des positiven Strom-Schwellwerts $|I_{set,p}|$ gleich gross sind.

**6.** Verfahren nach einem der Ansprüche 1 bis 5, **dadurch gekennzeichnet, dass** nach Ablauf der voraussichtlichen Zeitdauer $\Delta t$ von dem Erreichen des Strom-Schwellwerts bis zum Erreichen des Stromnulldurchgangs in mindestens einem Stromrichterzweig jeweils ein Stromventil geschaltet wird, welches jeweils einen Stromrichterzweig umschaltet zwischen einem Leitzustand und einem Sperrzustand.

**7.** Verfahren nach Anspruch 6, **dadurch gekennzeichnet, dass** das mindestens eine Stromventil nach einem Schaltvorgang erst nach einer Zeitverzögerung den jeweiligen Stromrichterzweig sperrt oder durchlässt und der Strom-Schwellwert $I_{set}$ so gross ist, dass die voraussichtliche Zeitdauer $\Delta t$ von dem Erreichen des Strom-Schwellwerts bis zum Erreichen des Stromnulldurchgangs grösser oder gleich der Zeitverzögerung bis zum bis zum Sperren oder Durchlassen ist und die Zeitverzögerung derart in der Ermittlung der voraussichtlichen Zeitdauer $\Delta t$ von dem Erreichen des Strom-Schwellwerts bis zum Erreichen des Stromnulldurchgangs berücksichtigt wird, dass das jeweilige Ventil zu einem Zeitpunkt vor einem Stromnulldurchgang, welcher der Zeitverzögerung entspricht, geschaltet wird und das Ventil zum Zeitpunkt des Stromnulldurchgangs sperrt oder durchlässt.

**8.** Vorrichtung zur Bestimmung des Zeitpunkts des Stromnulldurchgangs, **dadurch gekennzeichnet, dass** die Vorrichtung zur Bestimmung des Zeitpunkts des Stromnulldurchgangs Mittel zur Messung des Stroms am Eingang eines Stromrichterzweiges, Mittel zum Vergleichen des gemessenen Stromwerts mit einem Strom-Schwellwert und Mittel zur Ermittlung der voraussichtlichen Zeitdauer $\Delta t$ von dem Erreichen des Strom-Schwellwerts bis zum Erreichen des Stromnulldurchgangs anhand des Zeitpunkts, an dem der Strom den Wert des Strom-Schwellwerts vor dem Stromnulldurchgang erreicht, umfasst.

**9.** Umrichter, mindestens zwei Stromrichterzweige enthaltend, wobei der Strom abwechselnd über einen ersten und über einen zweiten Stromrichterzweig fliesst, **dadurch gekennzeichnet, dass** der Umrichter eine Vorrichtung zur Bestimmung des Zeitpunkts des Stromnulldurchgangs nach Anspruch 8 umfasst.

**Europäisches Patentamt**

## EUROPÄISCHER RECHERCHENBERICHT

Nummer der Anmeldung

EP 04 40 5635

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | US 6 535 402 B1 (YING JIANPING ET AL) 18. März 2003 (2003-03-18) * Zusammenfassung * * Abbildungen 8,11,12 * * Spalte 1, Zeilen 25-32 * * Spalte 2, Zeile 46 * * Spalte 5, Zeilen 15,16 * * Spalte 6, Zeilen 18-20 * * Spalte 6, Zeile 51 - Spalte 7, Zeile 7 * * Spalte 7, Zeilen 36-54 * * Anspruch 12 * | 1,6-9 | G01R19/175 H02M7/42 |
| A | | 5 | |
| A | OLIVEIRA A C ET AL: "Dead-time compensation in the zero-crossing current region" PESC'03. 2003 IEEE 34TH. ANNUAL POWER ELECTRONICS SPECIALISTS CONFERENCE. CONFERENCE PROCEEDINGS. ACAPULCO, MEXICO, JUNE 15 - 19, 2003, ANNUAL POWER ELECTRONICS SPECIALISTS CONFERENCE, NEW YORK, NY : IEEE, US, Bd. VOL. 4 OF 4. CONF. 34, 15. Juni 2003 (2003-06-15), Seiten 1937-1942, XP010648587 ISBN: 0-7803-7754-0 * Zusammenfassung * * Seite 1937, rechte Spalte - Seite 1939 * * Abbildungen 1-3 * | 1-9 | |
| A | PATENT ABSTRACTS OF JAPAN Bd. 007, Nr. 099 (E-172), 27. April 1983 (1983-04-27) -& JP 58 019167 A (TOKYO SHIBAURA DENKI KK), 4. Februar 1983 (1983-02-04) * Zusammenfassung * | 1,6-9 | |

RECHERCHIERTE SACHGEBIETE (Int.Cl.7)

G01R
H02M

-/--

Der vorliegende Recherchenbericht wurde für alle Patentansprüche erstellt

| Recherchenort | Abschlußdatum der Recherche | Prüfer |
|---|---|---|
| München | 23. März 2005 | Zettler, K-R |

Europäisches
Patentamt

**EUROPÄISCHER RECHERCHENBERICHT**

Nummer der Anmeldung

EP 04 40 5635

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| A | US 2002/089321 A1 (MATSUDA NAOTAKA) 11. Juli 2002 (2002-07-11) * Zusammenfassung * * Abbildungen 2,6 * * Absätze [0031] - [0037], [0052], [0055], [0068], [0071], [0074] * ----- | 1-9 | |
| A | PATENT ABSTRACTS OF JAPAN Bd. 2000, Nr. 03, 30. März 2000 (2000-03-30) -& JP 11 337629 A (MEIDENSHA CORP), 10. Dezember 1999 (1999-12-10) * Zusammenfassung * * Abbildung 9 * * Absätze [0005], [0006] * ----- | 1-9 | |

RECHERCHIERTE
SACHGEBIETE (Int.Cl.7)

Der vorliegende Recherchenbericht wurde für alle Patentansprüche erstellt

| Recherchenort | Abschlußdatum der Recherche | Prüfer |
|---|---|---|
| München | 23. März 2005 | Zettler, K-R |

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 04 40 5635

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

23-03-2005

| Im Recherchenbericht angeführtes Patentdokument | | Datum der Veröffentlichung | Mitglied(er) der Patentfamilie | | Datum der Veröffentlichung |
|---|---|---|---|---|---|
| US 6535402 | B1 | 18-03-2003 | CN | 1467907 A | 14-01-2004 |
| | | | TW | 588503 B | 21-05-2004 |
| JP 58019167 | A | 04-02-1983 | JP | 1669019 C | 29-05-1992 |
| | | | JP | 3032301 B | 10-05-1991 |
| US 2002089321 | A1 | 11-07-2002 | JP | 2002204581 A | 19-07-2002 |
| | | | DE | 10200332 A1 | 11-07-2002 |
| JP 11337629 | A | 10-12-1999 | KEINE | | |

EPO FORM P0461

Für nähere Einzelheiten zu diesem Anhang : siehe Amtsblatt des Europäischen Patentamts, Nr.12/82